(11) **EP 4 390 416 B1**

(12) **EUROPEAN PATENT SPECIFICATION**

(45) Date of publication and mention
of the grant of the patent:
**29.10.2025 Bulletin 2025/44**

(21) Application number: **22214914.8**

(22) Date of filing: **20.12.2022**

(51) International Patent Classification (IPC):
$G01R\ 31/367^{(2019.01)}$    $G01R\ 31/396^{(2019.01)}$
$G01R\ 31/3835^{(2019.01)}$    $B60L\ 58/18^{(2019.01)}$
$B60L\ 3/12^{(2006.01)}$    $G01R\ 31/3828^{(2019.01)}$
$G01R\ 31/3842^{(2019.01)}$

(52) Cooperative Patent Classification (CPC):
**G01R 31/396; B60L 3/12; B60L 58/18;**
**G01R 31/367; G01R 31/3835;** B60L 2240/547;
B60L 2240/549; G01R 31/3828; G01R 31/3842

(54) **CAPACITY AND STATE-OF-CHARGE ESTIMATION FOR A MULTI-BATTERY ENERGY STORAGE SYSTEM**

KAPAZITÄTS- UND LADUNGSZUSTANDSSCHÄTZUNG FÜR EIN MEHRBATTERIE-ENERGIESPEICHERSYSTEM

ESTIMATION DE CAPACITÉ ET D'ÉTAT DE CHARGE POUR UN SYSTÈME DE STOCKAGE D'ÉNERGIE À BATTERIES MULTIPLES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**26.06.2024 Bulletin 2024/26**

(73) Proprietor: **VOLVO TRUCK CORPORATION**
**405 08 Göteborg (SE)**

(72) Inventor: **ALTAF, Faisal**
**421 43 VÄSTRA FRÖLUNDA (SE)**

(74) Representative: **Kransell & Wennborg KB**
P.O. Box 2096
**403 12 Göteborg (SE)**

(56) References cited:
**US-A1- 2012 119 749**    **US-A1- 2013 271 068**
**US-A1- 2021 288 353**

• **DONG GUANGZHONG ET AL: "Determination of the load capability for a lithium-ion battery pack using two time-scale filtering", JOURNAL OF POWER SOURCES, ELSEVIER, AMSTERDAM, NL, vol. 480, 15 October 2020 (2020-10-15), XP086351099, ISSN: 0378-7753, [retrieved on 20201015], DOI: 10.1016/ J.JPOWSOUR.2020.229056**

**Description**

**TECHNICAL FIELD**

The disclosure is generally concerned with a multi-battery energy storage system (ESS) of parallel connected multi-battery units. In a particular aspect, the disclosure relates to a method of computing a state of charge of an energy storage system with multiple parallel battery packs.

**BACKGROUND**

The disclosure relates to capacity and state of charge (SoC) estimations for an ESS with multiple parallel battery packs. From the viewpoint of a user or an autonomous-driving software operating a vehicle, an accurate computation of capacity and SoC is critical as it has impact on vehicle performance, drivability, range. Operating a vehicle based on incorrect capacity and SoC computations may lead to reduced performance (i.e., reduced power and electric range). In addition, unbalanced capacity and SoC may also consequently lead to increased wear on the battery and consequently increased maintenance requirements.

In conventional approaches, estimating SoC and capacity for a larger system may be based on calculations on single-cell level. Although these calculations may be challenging per se, the complexity grows even further when estimating SoC and capacity of an ESS of parallel-connected battery units. Individual battery packs within a multi-battery ESS may exhibit non-homogeneous dynamic behaviours due to variations in internal and environmental parameters, which may include the battery packs having different charge levels, different ages, and/or being of different generations/types. Due to the complexity of these non-homogeneous dynamic behaviours, the problem of how to map individual battery states to a corresponding state of a multi-battery ESS has not yet been properly explored.

Conventional methods include operating the ESS based on average state estimates and constraints dictated by the weakest battery pack in the network. However, these approaches are prone to errors and may lead to under-utilization or over-utilization of available ESS capacity. Consequently, improved systems and methods are needed to calculate capacity and SoC in a multi-battery ESS network exhibiting complex non-homogeneous dynamics such that the full ESS capability is utilized.

US20210288353A1 discloses methods and electronic devices for estimating SoC of a battery pack. In particular, there is provided a model comprising an (electrical) equivalent circuit model, an electrochemical (thermal) model, and a (convective) thermal model. The model estimates parameters pertaining to each cell of the battery pack individually, and determines the variations in the values of the parameters among each of the cells of the battery pack. The parameters include capacity, temperature current, voltage, and SoC. The parameters are computed based on at current drawn by the battery pack, electrochemical parameters, thermal parameters, and cell internal and connection resistances of the individual cells. Various embodiments compute battery pack uptime, chargeable capacity of the battery pack and SoC of the battery pack, based on the values of the parameters.

US20130271068A1 addresses the prevention of degradation of battery cells (cells). A battery control apparatus obtains a cell voltage value of each of the cells, calculates a cell SoC at each of the cells based on the measured cell voltage value, calculates an integrated current value (Ah) by integrating current values of a battery pack configured with a plurality of the cells, calculates a cell capacity value of each of the cells based on the integrated current value and the cell SoC, calculates a dischargeable cell capacity value from the cell capacity value and the cell SoC, and controls charging/-discharging of the battery pack based on the dischargeable cell capacity value.

XP086351099 (Dong et al, Determination of the load capability for a lithium-ion battery pack using two time-scale filtering, Journal of Power Sources Volume 480, 31 December 2020, 229056) discloses a method for determining the load capability of a battery pack based on a two-time-scale filter using a combination of a recursive least-square method and a Kalman filter.

US20120119749A1 discloses a charge-state detection circuit, which detects a state of charge of a battery block in which are parallel-connected a plurality of series circuits of a secondary battery and a cutoff element which assumes a cutoff state of cutting off the charge/discharge path of the secondary battery and a conducting state different from the cutoff state. The charge state detection circuit comprises: an effective battery number detection portion which detects, as the number of effective batteries, the number of cutoff elements in the conducting state from among the plurality of cutoff elements included in the battery block; a capacity information generation portion which, based on the number of effective batteries, generates capacity information related to actual full charge capacity, which is the actual full charge capacity of the battery block; a total current detection portion, which detects as a total current value a current flowing in the entire battery block; an electricity quantity calculation portion, which calculates, as a stored electricity quantity, an electricity quantity stored in the battery block, by integrating the total current value; and a charge state detection portion, which, based on the capacity information and the stored electricity quantity, detects a state of charge, which is a ratio of the stored electricity quantity to the actual full charge capacity.

## SUMMARY

According to a first aspect of the invention, there is provided a method of computing a state of charge of an energy storage system (ESS) with multiple parallel battery packs. The method comprises: for each battery pack, predicting a time-evolved terminal voltage and current, including voltage/current values associated with future points in time, based on a respective measured terminal voltage and using a multi-battery system model; based on the predicted time-evolved terminal voltages and currents, computing a chargeable and/or dischargeable capacity of the ESS; and computing the State-of-Charge of the ESS based on the chargeable and/or dischargeable capacity of the ESS.

The first aspect of the invention may seek to provide an accurate computation of SoC for an ESS with multiple parallel battery packs such that the full capability (e.g., performance attribute such as useable energy and power ability, and long lifetime) of the ESS is utilized. The total capacity for the ESS is calculated by the sum of the chargeable and dischargeable capacity of the ESS, and the chargeable and dischargeable capacity of the ESS are based on the time evolution of the terminal voltage and current of each battery pack. The problem lies in that the time evolution of the terminal voltage and current of each battery pack is unknown and may be difficult to anticipate in the case of non-homogeneous battery packs. Calculating the SoC of the ESS based on estimates (in particular, based on a priori estimates) of the time-evolved terminal voltage and current, such as a pre-determined estimate given by a manufacturer, will result in an inaccurate estimate of available ESS capacity in a heterogeneous system. As an example, an estimated constraint dictated by the weakest battery pack will result in an under-estimation of the total available ESS capacity, especially since the estimated constrain may be set within safety margins to account for any standard deviations. By instead calculating the ESS capacity based on a prediction of a time-evolved terminal voltage and current, a better understanding is provided of how the dynamics of each battery pack contributes to the total ESS capacity, which in turn generates a more accurate computation of chargeable capacity, dischargeable capacity and/or SoC for the ESS. Consequently, a prediction of a time-evolved terminal voltage and current solves the problem of providing an accurate computation of SoC for an ESS with multiple parallel battery packs such that the full capability of the ESS is utilized.

In some embodiments, the chargeable capacity of the ESS is computed under an assumption of minimum charge time.

In some embodiments, the minimum charge time is calculated by calculating an expected charge time for each battery pack based on its time-evolved terminal voltage and selecting, from the expected charge times for all battery packs, the smallest expected charge time as said minimum charge time. By these steps, a dynamical behavior for each battery pack is derived based on the prediction of the time-evolved terminal voltage, outlining the dynamics on a single pack-level. The expected charge time may be rephrased as the time taken by a battery pack to charge from the current SoC level and reach the full charging state limit (and also achieve an equilibrium, at which the terminal voltage is approximately constant) for a given charging current. The minimum charge time provides an appropriate time-frame wherein the chargeable capacity of the ESS is evaluated. In selecting the smallest expected charge time as said minimum charge time, the minimum charge time will be dictated by the battery pack in the ESS that charges in shortest time.

In some embodiments, the dischargeable capacity of the ESS is computed under an assumption of minimum discharge time.

In some embodiments, the minimum discharge time is calculated by calculating an expected discharge time for each battery pack based on its time-evolved terminal voltage and selecting, from the expected discharge times for all battery packs, the smallest expected discharge time as said minimum charge time. By these steps, a dynamical behavior for each battery pack is derived based on the prediction of the time-evolved terminal voltage, outlining the dynamics on a single pack-level. The expected discharge time may be rephrased as the time taken by a battery pack to discharge from the current SoC level and reach an empty discharging state limit (and thus achieve equilibrium) for a given discharging current. The minimum discharge time provides an appropriate time-frame wherein the dischargeable capacity of the ESS is evaluated. In selecting the smallest expected discharge time as said minimum discharge time, the minimum discharge time will be dictated by the battery pack in the ESS that drains in shortest time.

In some embodiments, the time-evolved terminal voltages are predicted using a dynamic model of currents and voltages in a multi-battery system.

In some embodiments, the current for each battery pack is predicted using current split prediction based on a total reference ESS current and a measured terminal voltage for each battery pack.

Using the multi-battery system model allows for a smooth prediction for non-homogeneous battery packs leading to better predictions at any given time interval compared to prior art models, such as weakest link or average based models, which only converge towards accurate results at the end of maximum charge or discharge levels.

According to a second aspect of the invention, there is provided a processor device for computing a state of charge of an energy storage system, ESS, with multiple parallel battery packs. The device comprises an interface for receiving sensor signals associated with the ESS and processing circuitry configured to perform the method of any of the preceding claims.

According to a third aspect of the invention, there is provided a computer program product comprising program code for performing, when executed by the processor device, the method according to the first aspect of the invention.

According to a fourth aspect of the invention, there is provided a non-transitory computer-readable storage medium comprising instructions which, when executed by the processor device, cause the processor device to perform the method according to the first aspect of the invention.

The second, third and fourth aspects of the invention generally share the

effects and advantages of the first aspect, as discussed above, and they can be implemented with a corresponding degree of technical variation.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

## BRIEF DESCRIPTION OF THE DRAWINGS

With reference to the appended drawings, below follows a more detailed description of aspects of the disclosure cited as examples. In the drawings:

Fig. 1 is a block diagram of a system according to example embodiments of the invention;
Fig. 2 is a flowchart of method steps for computing a state of charge of an energy storage system, ESS, with multiple parallel battery packs;
Fig. 3 is a block diagram showing signal processing during operation of the system shown in Fig. 1, according to example embodiments of the invention; and
Fig. 4 shows example heavy commercial vehicles.

## DETAILED DESCRIPTION

The present invention will now be described more fully hereinafter with reference to the accompanying drawings, in which exemplary embodiments of the invention are shown. The invention may, however, be embodied in many different forms and should not be construed as limited to the embodiments set forth herein; rather, these embodiments are provided for thoroughness and completeness. The skilled person will recognize that many changes and modifications may be made within the scope of the appended claims. Like reference characters refer to like elements throughout the description.

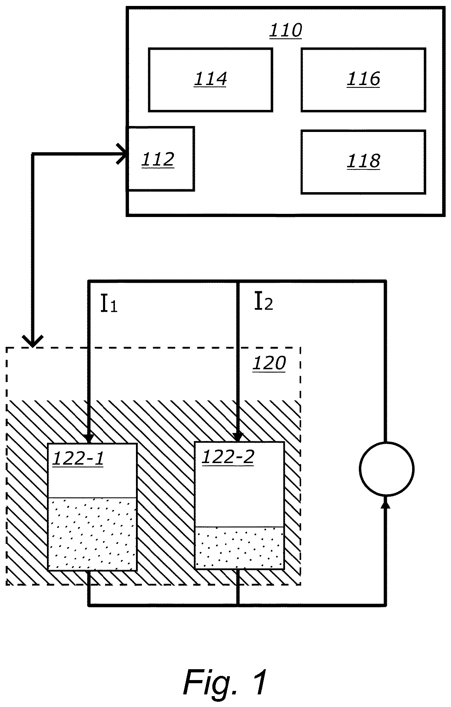

Fig. 1 conceptually illustrates a non-limiting example wherein the ESS 120 comprises two parallel connected battery packs 122-1, 122-2. However, it is understood that the ESS 120 may consist of any number of multiple battery packs 122, connected in parallel or in series. The present disclosure is mainly concerned with the case of parallel battery packs 122. A battery pack 122 may comprise at least one battery module, which in turn may comprise at least one battery cell. The battery packs 112 are configured to provide propulsion and/or power to a vehicle, but may be used in other fields such as for powering electrical devices, power tools, backup power systems, or power generation devices.

Fig. 1 further shows a processor device 110 receiving input parameters from the ESS through an interface 112, the processor device 110 having access to instructions for executing the method of the disclosure via the storage medium 116. In particular, the storage medium 116 may store a computer program 118 comprising program code for performing the method of the disclosure. The processor device 110 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device 110 may further include an external interface (not shown) allowing it to communicate with at least one analogously configured further device via a communication network (local-area network, wide-area network, intranet, extranet, Internet), and/or with a server or another host computer. The processor device 110 may be used for data logging on-board regarding ESS usage. The logged data may be sent to a remote server (not shown) for further data analytics and insights.

The interface 112 receives sensor signals associated with the ESS. The sensors are configured to collect data indicative of characteristics and parameters of the ESS, such as the measured terminal voltage. Such sensors may be voltage and/or current sensor for detecting a voltage of each battery pack 122, or an electrical discharge or charge current of each battery pack 122. The sensors may also include temperature sensors for measuring a temperature of each battery pack 122 or be configured to acquired drive pattern data that may indicate driver style or vehicle usage type. Because the ESS 120 includes multiple battery packs 122, even though measurements are not necessarily performed on the levels below a battery pack (such as battery module, battery cell), there will be multiple measured voltages and/or currents available. The present disclosure proposes an efficient and precise approach for processing and utilizing this information to support a better understanding and usage of the ESS 120, especially in an electric vehicle. The interface 112 outputs the collected sensor data indicative of characteristics and parameters of the ESS in a digital format. The output data may be accessed by the processing circuitry 114 and computer program 118 for causing the processor device to perform the method of the disclosure.

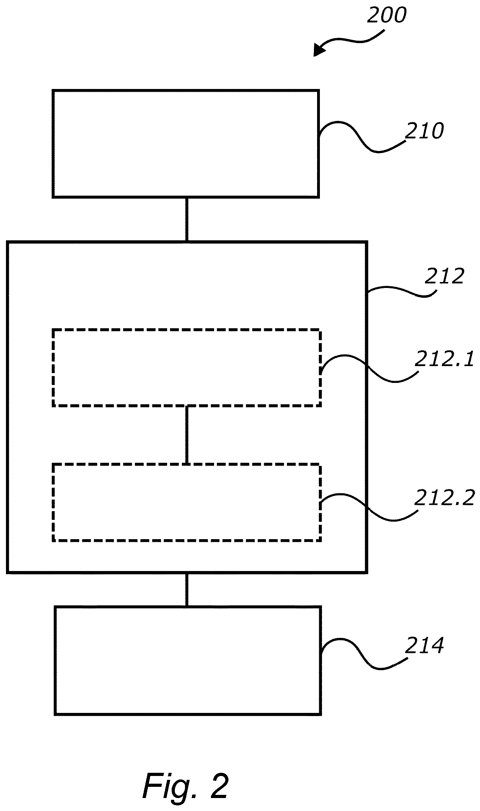

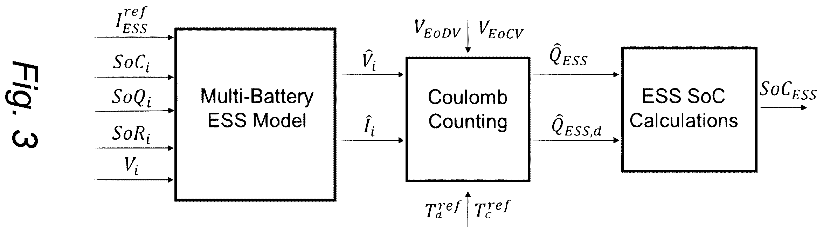

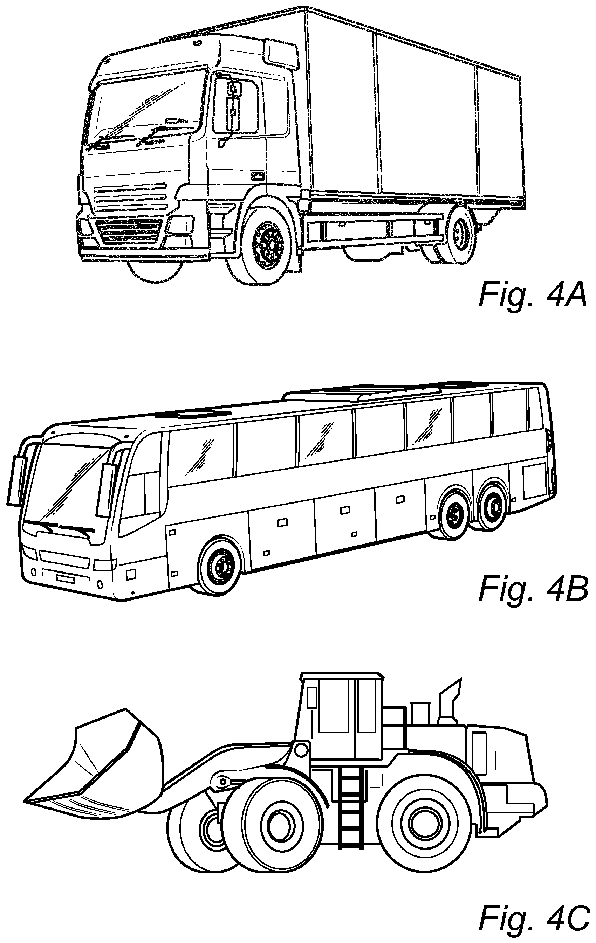

Fig. 2 is a flowchart of a method 200 for computing a state of charge of an ESS 120 with multiple parallel battery packs 122, like the one that has been described with reference to Fig. 1. The method 200 can be implemented in a processor device 110 of the type also shown in Fig. 1, which has access to terminal voltage of each of the battery packs 122 of the ESS 120. The description of the method 200, which now follows, can be understood with further reference to Fig. 3, which illustrates certain information flows and/or signal processing that may occur while the method 200 is performed. The method 200 may be implemented in a vehicle, such as the truck, bus and construction equipment shown in Fig. 4. The vehicles may be conventional or autonomous (driverless). The vehicles may carry the processor device 110 and sensors configured to collect data indicative of characteristics and parameters of the ESS.

In a first step 210 of the method 200, a terminal voltage of each battery pack 122 is obtained (e.g., by performing a measurement or receiving measurement data from an external source), and a respective time-evolved terminal voltage and current are predicted based thereon. The time-evolved terminal voltage/current is represented as a sequence of voltage/current values associated with future points in time and is predicted by a multi-battery system model. The current obtained from the multi-battery system model is directly used as an input for step 212 wherein the chargeable/dischargeable capacity of the ESS 120 is computed, and the time-evolved terminal voltage may be further evaluated to obtain the expected charge/discharge time for each battery pack.

The current for each battery pack 122 may be a predicted charge and/or discharge current for a battery pack, and may be determined by current split prediction from a multi-battery system model. The simplest case of current split prediction imposes the constraint of the sum of all currents being equal to the total reference ESS current (Kirchhoff's current law and Kirchhoff's voltage law), wherein the total reference ESS current may be based on manufacturer specified charging current profile, offline "charge capacity" testing and characterization, or historical charging history on ESS level logged by the processor device 110. Further input parameters such as impedances, resistances, capacities, voltages, and temperature may be taken into account for the current-split prediction. The current for each battery pack 122 may be a time-dependent function or a constant and may be different based on whether the battery is charging or discharging.

A multi-battery system model may be configured to predict the time taken by each battery pack 122 to reach steady-state voltage value at the end of a charge and/or discharge cycle between different electrical energy storage packs in the ESS 120. A large number of useful multi-battery system models have been described in the literature. For example, the multi-battery system model may approximate a single battery pack 122 as a circuit consisting of a resistor and a capacitor pair connected in parallel. To model the full multi-battery ESS 120, several such pairs are connected in series and in parallel. In general, a multi-battery system model may use, in addition to the measured voltage, further input parameters such as battery temperature and/or a setpoint charge/discharge-current profile, but may use other input parameters such as open circuit voltage, impedances, capacities, cable connection resistance, temperature, SoC, state of current (SoQ), and/or state of resistance (SoR) for each battery unit, and/or a total flow current for the ESS 120. The multi-battery system model may be mathematically represented in the form of differential equations or in state-space form. Any examples of the multi-battery system model as disclosed by the applicant in WO2020128066, WO2020128068, WO2021121672 and WO2021121673, herein incorporated by reference, may be used to predict the time-evolved terminal voltages and/or currents for each battery pack.

Predicting the time-evolved terminal voltages and current for each battery pack 122 may further be based on other types of models or even look-up tables. The multi-battery model may take into account the effect of temperature variations, and may also include a simple thermal model to predict the temperature evaluation during various operating conditions.

In second step 212 in the method 200, the chargeable/dischargeable capacity of the ESS 120 is being computed using a Coulomb-counting approach, wherein the battery current during charge and discharge is temporally integrated. On a single pack level, each battery pack i has a chargeable capacity $Q_{c,i}$ representing the current flow during the time it takes to reach a fully charged state from its current SoC level, and a dischargeable capacity $Q_{d,i}$ representing the current flow during the time it takes to reach an empty state from its current SoC level. The dischargeable and chargeable capacities computed by the Coulomb counting approach may be expressed as

$$\hat{Q}_{d,ESS}(t) = \int_{t}^{t+T_d^{ref}} \sum_i \hat{I}_{d,i}^{ref}(\tau)d\tau$$

$$\hat{Q}_{c,ESS}(t) = \int_{t}^{t+T_c^{ref}} \sum_{i} \hat{I}_{c,i}^{ref}(\tau) d\tau$$

where $T_c^{ref}$ and $T_d^{ref}$ represent the minimum charge time and minimum discharge times from current SoC level, $t$ is the time at which the measured terminal voltage is obtained, and $\hat{I}_{c,i}^{ref}$ and $\hat{I}_{d,i}^{ref}$ are the predicted charge and discharge currents for an $i^{th}$ battery pack 122. The predicted charge and discharge currents can be determined by applying current split prediction to a predefined total charge and total discharge current trajectory $I_{c,ESS}^{ref}, I_{d,ESS}^{ref}$, respectively, using a multi-battery system model. It is understood that the above integrals are normally to be evaluated numerically.

Computing the chargeable and/or dischargeable capacity of the ESS 120 may be based on other known methods, such as Kalman filter method, Luenberger observer method, proportional integral method, sliding mode method, or data-oriented methods such as using neural network, fuzzy logic or support vector machine model.

In a third step 214 in the method 200 shown in Fig. 2, the SoC of the ESS 120 is computed using the chargeable and/or dischargeable capacities of the ESS 120. The total capacity for one battery pack 122 will then be expressed as the sum of chargeable and dischargeable capacities,

$$Q_i(t) = Q_{c,i}(t) + Q_{d,i}(t)$$

In the same way, the total capacity for the ESS 120 is given by

$$Q_{ESS}(t) = Q_{d,ESS}(t) + Q_{c,ESS}(t)$$

as further illustrated in Fig. 1. The SoC of the total ESS 120 may then be computed using any two of either the total capacity, the chargeable capacity, or the dischargeable capacity as given by the relationship

$$Q_{c,ESS}(t) = [1 - SoC(t)] \cdot Q_{ESS}(t)$$

Optionally, in some embodiments, the second step 212 includes a substep 212.1, where the expected charge/discharge time for each battery pack 122 is calculated. The predicted time-evolved terminal voltage obtained from the multi-battery system model provides an indication of the dynamical behaviour of each battery pack, and the expected charge/discharge time for each battery may thus be calculated by imposing boundary conditions on the time-evolved terminal voltage.

For each battery pack, an initial time may correspond to the time of measurement of the measured terminal voltage, and a final time may correspond to the time of reaching a charging/discharging limit voltage. The expected charge/discharge time for each battery pack 122 is then given by minimizing the time-frame between the initial time and final time, and may in an exemplary embodiment be expressed as

$$T_{c,i}^{ref} = \min\left\{(t_f - t_0) \,\middle|\, \hat{V}_i(t_0) = V_i(t) \,\&\, \hat{V}_i(t_f) = V_{EoCV,i} \,\&\, \dot{\hat{V}}_i(t_f) = 0\right\}, \forall i$$

$$T_{d,i}^{ref} = \min\left\{(t_f - t_0) \,\middle|\, \hat{V}_i(t_0) = V_i(t) \,\&\, \hat{V}_i(t_f) = V_{EoDVd,i} \,\&\, \dot{\hat{V}}_i(t_f) = 0\right\}, \forall i$$

wherein $T_{d,i}^{ref}$ and $T_{c,i}^{ref}$ represent the expected charge time and expected discharge time, $V_i(t)$ represent the measured terminal voltage at time $t$, $t_o$ represent the initial time, $t_f$ represent the final time and $V_{EoCV,i}$ and $V_{EoDV,i}$ represent the charging and discharging limit voltage. The conditions $\hat{V}_i(t_f) = V_{EoCV,i} \,\&\, \dot{\hat{V}}_i(t_f) = 0$ and

$\hat{V}_i(t_f) = V_{EoDV,i} \,\&\, \dot{\hat{V}}_i(t_f) = 0$ may be referred to as a termination criterion. The equality signs herein represent equality within approximation (e.g., $|\hat{V}_i(t_0) - V_i(t)| \leq \varepsilon$, where $\varepsilon > 0$ is an acceptable tolerance) rather than a strict equality, as it is understood that in a real case scenario, a battery pack 122 may not reach a definite equilibrium. Rather, the equality signs herein represent an illustrative idealization of the dynamics.

The charging limit voltage is the voltage level at which the battery pack 122 is considered fully charged/-discharged and may be set individually to a nominally fully charged/discharged level or an extended fully charged/-discharged level below or above the nominally fully charged/discharged level. The equilibrium condition corresponds to the level of saturation of charge in the battery pack 122 wherein the instantaneous rate of change for the time-evolved terminal voltage reaches, or approaches, zero. The charging/discharged limit voltage and equilibrium condition may be assumed, such as based on data obtained from a manufacturer or provider, based on measurements on the battery pack, calculated by the battery management system or obtained from a look-up table and may be set manually or automatically based on external or internal parameters such as vehicle performance requirements, route planning, driving data, lifetime, durability requirements, or battery cell parameters.

In some embodiments, the method 200 further comprises a substep 212.2, in which the minimum charge/-discharge time are calculated by selecting the smallest expected charge time from the expected charge times for all battery packs 122, that is,

$$T_c^{ref} = \min_{i}\big(T_{c,i}^{ref}\big), \ \ T_d^{ref} = \min_{i}\big(T_{d,i}^{ref}\big)$$

where $T_d^{ref}$ and $T_c^{ref}$ are the minimum discharge/charge times representing the discharge-time-to-empty and charge-time-to-full of ESS 120 and are dictated by the battery pack 122 in ESS 120 that drains/fills at fastest rate.

Fig. 3 shows signal processing taking place in a processor device 110 that executes the method 200. The notation is consistent with one used in the foregoing description. The input parameters for predicting the time-evolved terminal voltage and current in a first step of using the multi-battery system model are the total ESS current $I_{ESS}^{ref}$, which may be total demanded input current, the state-of-charge for each battery pack $SoC_i$, the state-of-capacity for each battery pack $SoQ_i$, and the state-of-resistance for each battery pack $SoR_i$, which may be estimated based on battery aging. The model may use further system parameters such as battery impedances, capacities, resistances, and/or temperatures. The model further uses a measured terminal voltage $V_i(t)$ for each battery pack 122 as input parameters, wherein the measurements may be done by sensors configured to send the measured input data to the processor device 110 via the interface 112. Optionally, the model may use a measured current, temperature and/or SoC as input.

From the multi-battery system model, the predicted time-evolved terminal voltage $\hat{V}_i$ and current $\hat{I}_i$ are obtained (the time dependences omitted for clarity). The time-evolved terminal voltage and current are time-evolved in the sense that they represent a sequence of voltage/current values along a predicted trajectory in a time-frame $t + T$, wherein $t$ is the time of measurement of the measured terminal voltage, and $T$ is a prediction time period in future. In other words, the time-evolved terminal voltage and current are predicted not only for a given instant in time, but also for a period of time adjacent to the given instant. The predicted time-evolved terminal voltage and current are then used to calculate the chargeable/dischargeable capacity as described in step 212 of Fig. 2.

## Claims

1. A method (200) of computing a state of charge of an energy storage system, ESS (120), with multiple parallel battery packs, the method **characterized by** comprising:

   for each battery pack, predicting (210) a time-evolved terminal voltage and current, including voltage/current values associated with future points in time, based on a respective measured terminal voltage and using a multi-battery system model;
   based on the predicted time-evolved terminal voltages and currents, computing (212) a chargeable and/or dischargeable capacity of the ESS; and
   computing (214) the state of charge of the ESS based on the chargeable and/or dischargeable capacity of the ESS.

2. The method of claim 1, wherein the chargeable and/or dischargeable capacity of the ESS is computed (212) using a Coulomb-counting approach.

3. The method of any of the preceding claims, wherein the chargeable capacity of the ESS is computed (212) under an assumption of minimum charge time.

4. The method of claim 3, wherein the minimum charge time is calculated by:

calculating (212.1) an expected charge time for each battery pack based on its time-evolved terminal voltage; and
selecting (212.2), from the expected charge times for all battery packs, the smallest expected charge time as said minimum charge time.

5. The method of claim 4, wherein the expected charge time is calculated by applying to the time-evolved terminal voltage a termination criterion including a charging limit voltage and an equilibrium condition.

6. The method of any of the preceding claims, wherein the dischargeable capacity of the ESS is computed (212) under an assumption of minimum discharge time.

7. The method of claim 6, wherein the minimum discharge time is calculated by:

calculating (212.1) an expected discharge time for each battery pack based on its time-evolved terminal voltage; and
selecting, (212.2) from the expected discharge times for all battery packs, the smallest expected discharge time as said minimum charge time.

8. The method of claim 7, wherein the expected discharge time is calculated by applying to the time-evolved terminal voltage a termination criterion including a discharging limit voltage and an equilibrium condition.

9. The method of any of the preceding claims, wherein the multi-battery system model, by which the time-evolved terminal voltages are predicted (110), is a dynamic model of currents and voltages in a multi-battery system.

10. The method of claim 9, wherein the model is variable with respect to battery temperature and/or a setpoint charge/discharge-current profile.

11. The method of any of the preceding claims, wherein the current for each battery pack is predicted (210) using current split prediction based on a total reference ESS current and a measured terminal voltage for the battery pack.

12. The method of any of the preceding claims, wherein the ESS is a vehicular ESS.

13. A processor device (110) for computing a state of charge of an energy storage system, ESS, (120) with multiple parallel battery packs (122-1, 122-2), the device comprising:

an interface (112) for receiving sensor signals associated with the ESS; and
processing circuitry (114) configured to perform the method of any of the preceding claims.

14. A computer program product (118) comprising program code for performing, when executed by the processor device (110) of claim 13, the method of any of claims 1 to 12.

15. A non-transitory computer-readable storage medium (116) comprising instructions which, when executed by the processor device (110) of claim 13, cause the processor device to perform the method of any of claims 1 to 12.

**Patentansprüche**

1. Verfahren (200) zum Berechnen eines Ladungszustands eines Energiespeichersystems, ESS (120), mit mehreren parallelen Batteriepacks, wobei das Verfahren **dadurch gekennzeichnet ist, dass** es umfasst:

für jedes Batteriepack, Vorhersagen (210) einer zeitabhängigen Klemmenspannung und eines zeitabhängigen Stroms, einschließlich Spannungs-/Stromwerten, die zukünftigen Zeitpunkten zugeordnet sind, auf der Grundlage einer jeweiligen gemessenen Klemmenspannung und unter Verwendung eines Mehrbatterie-Systemmodells;
Berechnen (212) einer aufladbaren und/oder entladbaren Kapazität des ESS auf der Grundlage der vorhergesagten zeitabhängigen Klemmenspannungen und -ströme; und
Berechnen (214) des Ladungszustands des ESS auf der Grundlage der aufladbaren und/oder entladbaren Kapazität des ESS.

2. Verfahren nach Anspruch 1, wobei die aufladbare und/oder entladbare Kapazität des ESS unter Verwendung eines Coulomb-Zählungsansatzes berechnet wird (212).

3. Verfahren nach einem der vorhergehenden Ansprüche, wobei die aufladbare Kapazität des ESS unter der Annahme einer Mindestladungszeit berechnet wird (212).

4. Verfahren nach Anspruch 3, wobei die Mindestladungszeit berechnet wird durch:

Berechnen (212.1) einer erwarteten Ladungszeit für jedes Batteriepack auf der Grundlage seiner zeitabhängigen Klemmenspannung; und
Auswählen (212.2) der kleinsten erwarteten Ladungszeit aus den erwarteten Ladungszeiten für alle Batteriepacks als Mindestladungszeit.

5. Verfahren nach Anspruch 4, wobei die erwartete Ladungszeit berechnet wird, indem auf die zeitabhängige Klemmenspannung ein Abbruchkriterium angewendet wird, das eine Ladungsgrenzspannung und eine Gleichgewichtsbedingung aufweist.

6. Verfahren nach einem der vorhergehenden Ansprüche, wobei die entladbare Kapazität des ESS unter der Annahme einer Mindestentladungszeit berechnet wird (212).

7. Verfahren nach Anspruch 6, wobei die Mindestentladungszeit berechnet wird durch:

Berechnen (212.1) einer erwarteten Entladungszeit für jedes Batteriepack auf der Grundlage seiner zeitabhängigen Klemmenspannung; und
Auswählen (212.2) der kleinsten erwarteten Entladungszeit aus den erwarteten Entladungszeiten für alle Batteriepacks als Mindestladungszeit.

8. Verfahren nach Anspruch 7, wobei die erwartete Entladungszeit berechnet wird, indem auf die zeitabhängige Klemmenspannung ein Abbruchkriterium angewendet wird, das eine Entladungsgrenzspannung und eine Gleichgewichtsbedingung aufweist.

9. Verfahren nach einem der vorhergehenden Ansprüche, wobei das Mehrbatterie-Systemmodell, mit dem die zeitabhängigen Klemmenspannungen vorhergesagt werden (110), ein dynamisches Modell der Ströme und Spannungen in einem Mehrbatteriesystem ist.

10. Verfahren nach Anspruch 9, wobei das Modell in Bezug auf die Batterietemperatur und/oder ein Sollwert-Ladungs/-Entladungsstromprofil variabel ist.

11. Verfahren nach einem der vorhergehenden Ansprüche, wobei der Strom für jedes Batteriepack vorhergesagt wird (210), indem die Stromaufteilungsvorhersage auf der Grundlage eines gesamten ESS-Referenzstroms und einer gemessenen Klemmenspannung für das Batteriepack verwendet wird.

12. Verfahren nach einem der vorhergehenden Ansprüche, wobei das ESS ein Fahrzeug-ESS ist.

13. Prozessorvorrichtung (110) zum Berechnen eines Ladungszustands eines Energiespeichersystems, ESS, (120) mit mehreren parallelen Batteriepacks (122-1, 122-2), die Vorrichtung umfassend:

eine Schnittstelle (112) zum Empfangen von Sensorsignalen, die mit dem ESS verbunden sind; und
eine Verarbeitungsschaltung (114), die konfiguriert ist, um das Verfahren nach einem der vorhergehenden Ansprüche durchzuführen.

14. Computerprogrammprodukt (118) umfassend einen Programmcode zum Durchführen des Verfahrens nach einem der Ansprüche 1 bis 12, wenn es von einer Prozessorvorrichtung (110) nach Anspruch 13 ausgeführt wird.

15. Nicht-transitorisches computerlesbares Speichermedium (116), das Anweisungen umfasst, die, wenn sie von einer Prozessorvorrichtung (110) nach Anspruch 13 ausgeführt werden, die Prozessorvorrichtung veranlassen, das Verfahren nach einem der Ansprüche 1 bis 12 durchzuführen.

**Revendications**

1. Procédé (200) de calcul d'un état de charge d'un système de stockage d'énergie, ESS (120), avec plusieurs blocs-batteries parallèles, le procédé étant **caractérisé en ce qu'**il comprend :

   pour chaque bloc de batteries, la prédiction (210) d'une tension et d'un courant aux bornes évoluant dans le temps, y compris des valeurs de tension/courant associées à des points futurs dans le temps, sur la base d'une tension aux bornes mesurée correspondante et l'utilisation d'un modèle de système multi-batteries ;
   sur la base des tensions et courants aux bornes prédits évoluant dans le temps, le calcul (212) d'une capacité de charge et/ou de décharge de l'ESS ; et
   le calcul (214) de l'état de charge de l'ESS sur la base de la capacité de charge et/ou de décharge de l'ESS.

2. Procédé selon la revendication 1, dans lequel la capacité de chargement et/ou de déchargement de l'ESS est calculée (212) en utilisant une approche de comptage de Coulomb.

3. Procédé selon l'une quelconque des revendications précédentes, dans lequel la capacité de charge de l'ESS est calculée (212) sous l'hypothèse d'un temps de charge minimum.

4. Procédé selon la revendication 3, dans lequel le temps de charge minimum est calculé en :

   calculant (212.1) un temps de charge attendu pour chaque bloc de batteries sur la base de sa tension terminale évoluant dans le temps ; et
   sélectionnant (212.2), parmi les temps de charge attendus pour tous les blocs de batteries, le temps de charge attendu le plus réduit comme temps de charge minimum.

5. Procédé selon la revendication 4, dans lequel le temps de charge attendu est calculé en appliquant à la tension aux bornes évoluant dans le temps un critère de terminaison comprenant une tension limite de charge et une condition d'équilibre.

6. Procédé selon l'une quelconque des revendications précédentes, dans lequel la capacité de décharge de l'ESS est calculée (212) en supposant un temps de décharge minimum.

7. Procédé selon la revendication 6, dans lequel le temps de décharge minimum est calculé en :

   calculant (212.1) un temps de décharge attendu pour chaque bloc de batteries sur la base de sa tension de borne évoluant dans le temps ;
   et sélectionnant (212.2) à partir des temps de décharge attendus pour tous les blocs de batteries, le temps de décharge le plus réduit comme temps de charge minimum.

8. Procédé selon la revendication 7, dans lequel le temps de décharge attendu est calculé en appliquant à la tension aux bornes évoluant dans le temps un critère de terminaison comprenant une tension limite de décharge et une condition d'équilibre.

9. Procédé selon l'une quelconque des revendications précédentes, dans lequel le modèle de système multi-batteries, par lequel les tensions de borne évoluant dans le temps sont prédites (110), est un modèle dynamique de courants et de tensions dans un système multi-batteries.

10. Procédé selon la revendication 9, dans lequel le modèle est variable par rapport à la température de la batterie et/ou à un profil de courant de charge/décharge de point de consigne.

11. Procédé selon l'une quelconque des revendications précédentes, dans lequel le courant pour chaque bloc de batterie est prédit (210) en utilisant une prédiction fractionnée de courant basée sur un courant ESS de référence total et une tension aux bornes mesurée pour le bloc de batteries.

12. Procédé selon l'une quelconque des revendications précédentes, dans lequel l'ESS est un ESS de véhicule.

**13.** Dispositif processeur (110) pour calculer un état de charge d'un système de stockage d'énergie, ESS, (120) avec plusieurs blocs de batteries parallèles (122-1, 122-2), le dispositif comprenant :

une interface (112) pour recevoir des signaux de capteur associés à l'ESS ; et
un circuit de traitement (114) configuré pour exécuter le procédé selon l'une quelconque des revendications précédentes.

**14.** Produit de programme informatique (118) comprenant un code de programme pour exécuter, lorsqu'il est exécuté par le dispositif de processeur (110) selon la revendication 13, le procédé selon l'une quelconque des revendications 1 à 12.

**15.** Support de stockage non transitoire lisible par ordinateur (116) comprenant des instructions qui, lorsqu'elles sont exécutées par le dispositif processeur (110) selon la revendication 13, amènent le dispositif processeur à exécuter le procédé selon l'une quelconque des revendications 1 à 12.

*Fig. 1*

Fig. 2

Fig. 3

Fig. 4A

Fig. 4B

Fig. 4C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20210288353 A1
- US 20130271068 A1
- US 20120119749 A1
- WO 2020128066 A
- WO 2020128068 A
- WO 2021121672 A
- WO 2021121673 A

**Non-patent literature cited in the description**

- **DONG et al.** Determination of the load capability for a lithium-ion battery pack using two time-scale filtering. *Journal of Power Sources*, 31 December 2020, vol. 480, 229056